(19) Europäisches Patentamt / European Patent Office / Office européen des brevets

(11) **EP 2 680 609 A1**

(12) **EUROPEAN PATENT APPLICATION**
published in accordance with Art. 153(4) EPC

(43) Date of publication:
**01.01.2014 Bulletin 2014/01**

(51) Int Cl.:
***H04R 3/02*** (2006.01)

(21) Application number: **12749314.6**

(22) Date of filing: **14.02.2012**

(86) International application number:
**PCT/JP2012/053418**

(87) International publication number:
**WO 2012/114946 (30.08.2012 Gazette 2012/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.02.2011 JP 2011036221**

(71) Applicant: **Sony Corporation
Tokyo 108-0075 (JP)**

(72) Inventors:
- **SAKURABA, Yohei
  Tokyo 108-0075 (JP)**
- **KIHARA, Nobuyuki
  Tokyo 108-0075 (JP)**

(74) Representative: **Mills, Julia
D Young & Co LLP
120 Holborn
London EC1N 2DY (GB)**

(54) **AUDIO PROCESSING DEVICE, AUDIO PROCESSING METHOD, AND PROGRAM**

(57) Provided is an audio processing apparatus including a frequency domain conversion unit configured to convert an audio signal input from a microphone to a frequency domain for each of frames, and a gain adjustment unit configured to perform gain adjustment for each of bands on the audio signal converted to the frequency domain. The gain adjustment unit acquires an autocorrelation value of power of the audio signal between the frames for each of the bands, and sets an adjustment amount of the gain in accordance with the acquired autocorrelation value.

**FIG. 1**

**Description**

Technical Field

The present invention relates to an audio processing apparatus, an audio processing method, and a program.

Background Art

It has been known that so-called howling occurs in various audio signal transmission systems such as an audio amplification system from a microphone to a speaker. It is an important issue to suppress this howling.

For example, technologies disclosed in Patent Literatures 1 and 2 are used as a way of suppressing howling. Patent Literature 1 discloses a technique for detecting occurrence of howling upon detecting an envelope increase tendency that continues for a predetermined time or more. Patent Literature 2 discloses a technique for gradually suppressing howling.

Citation List

Patent Literature

[0004]

　　　Patent Literature 1: JP H8-223684A

　　　Patent Literature 2: JP H3-237899A

Summary of Invention

Technical Problem

However, even if the techniques described above are adopted, it is impossible to appropriately detect howling in the actual environment due to influences of various reflected sounds, which arrive with delay, and various non-howling sounds such as a noise and a voice to be input to a microphone. Consequently, there is a problem that howling is not properly suppressed.

In view of the problem, the object of the present disclosure is to provide an audio processing device, an audio processing method, and a program that are novel and improved, and are capable of properly suppressing howling even if a reflected sound or a non-howling sound occurs.

Solution to Problem

According to the first aspect of the present disclosure in order to solve the above-mentioned problem, there is provided an audio processing apparatus including a frequency domain conversion unit configured to convert an audio signal input from a microphone to a frequency domain for each of frames, and a gain adjustment unit configured to perform gain adjustment for each of bands on the audio signal converted to the frequency domain. The gain adjustment unit acquires an autocorrelation value of power of the audio signal between the frames for each of the bands, and sets an adjustment amount of the gain in accordance with the acquired autocorrelation value.

The adjustment amount may include a first suppression amount having a long time for suppressing the gain, and a second suppression amount having a short time for suppressing the gain.

The gain adjustment unit may set a combined suppression amount for each of the bands, the combined suppression amount being a combination of the first suppression amount and the second suppression amount.

The gain adjustment unit may set the combined suppression amount obtained by increasing the first suppression amount when a maximum value of the acquired autocorrelation value is greater than a predetermined threshold value, and sets the combined suppression amount obtained by increasing the second suppression amount when the maximum value of the acquired autocorrelation value is smaller than the threshold value.

The autocorrelation value of the power may be an absolute value of an autocorrelation normalized based on the power.

A time domain conversion unit configured to convert the audio signal subjected to gain adjustment by the gain adjustment unit to a time domain, and an output unit configured to output the audio signal converted to the time domain to a speaker may further be included.

A coefficient conversion unit configured to convert a filter coefficient to a minimum phase filter coefficient, the filter coefficient corresponding to the adjustment amount of the gain according to the autocorrelation value, and a convolution unit configured to convolute the minimum phase filter coefficient with the audio signal in the time domain, the audio signal being input from the microphone may further be included.

According to another aspect of the present disclosure in order to solve the above-mentioned problem, there is provided an audio processing apparatus including a frequency domain conversion unit configured to convert an audio signal input from a microphone to a frequency domain for each of frames, and a gain adjustment unit configured to perform gain adjustment for each of bands on the audio signal converted to the frequency domain. The gain adjustment unit adjusts the gain for each of the bands with a combined suppression amount obtained by combining a first suppression amount having a long suppression time with a second suppression amount having a short suppression time.

According to another aspect of the present disclosure in order to solve the above-mentioned problem, there is provided an audio processing method including converting an audio signal input from a microphone to a frequency domain for each of frames, and performing gain adjustment for each of bands on the audio signal converted to the frequency domain. In performing the gain adjustment, an autocorrelation value of power of the audio signal between the frames for each of the bands is acquired, and an adjustment amount of the gain is set in accordance with the acquired autocorrelation value.

According to another aspect of the present disclosure in order to solve the above-mentioned problem, there is provided an audio processing method including converting an audio signal input from a microphone to a frequency domain for each of frames, and performing gain adjustment for each of bands on the audio signal converted to the frequency domain. In performing the gain adjustment, the gain is adjusted for each of the bands with a combined suppression amount obtained by combining a first suppression amount having a long suppression time with a second suppression amount having a short suppression time.

According to another aspect of the present disclosure in order to solve the above-mentioned problem, there is provided a program for causing a computer to function as an audio processing apparatus, the audio processing apparatus including a frequency domain conversion unit configured to convert an audio signal input from a microphone to a frequency domain for each of frames, and a gain adjustment unit configured to perform gain adjustment for each of bands on the audio signal converted to the frequency domain. The gain adjustment unit acquires an autocorrelation value of power of the audio signal between the frames for each of the bands, and sets an adjustment amount of the gain in accordance with the acquired autocorrelation value.

According to another aspect of the present disclosure in order to solve the above-mentioned problem, there is provided a program for causing a computer to function as an audio processing apparatus, the audio processing apparatus including a frequency domain conversion unit configured to convert an audio signal input from a microphone to a frequency domain for each of frames, and a gain adjustment unit configured to perform gain adjustment for each of bands on the audio signal converted to the frequency domain. The gain adjustment unit adjusts the gain for each of the bands with a combined suppression amount obtained by combining a first suppression amount having a long suppression time with a second suppression amount having a short suppression time.

Advantageous Effects of Invention

As described above, according to the present invention, it is possible to properly suppress howling even if a reflected sound or a non-howling sound occurs.

Brief Description of Drawings

[FIG. 1] FIG. 1 is a functional block diagram of an audio processing apparatus according to a first embodiment.
[FIG. 2] FIG. 2 is a schematic view for describing block processing.
[FIG. 3A] FIG. 3A is a diagram illustrating a power difference $\Delta p(\omega)$ in one band.
[FIG. 3B] FIG. 3B is a diagram illustrating absolute values of an autocorrelation normalized based on power.
[FIG. 4] FIG. 4 is a flowchart describing howling suppression processing.
[FIG. 5] FIG. 5 is a functional block diagram of an audio processing apparatus according to a second embodiment.
[FIG. 6] FIG. 6 is a diagram for describing a linear phase FIR filter coefficient.
[FIG. 7] FIG. 7 is a diagram for describing conversion of a FIR filter coefficient to a minimum phase FIR filter coefficient.

Description of Embodiments

Hereinafter, preferred embodiments of the present invention will be described in detail with reference to the appended drawings. Note that, in this specification and the drawings, elements that have substantially the same function and structure are denoted with the same reference signs, and repeated explanation is omitted.

The description will be made in the following order.

1. First Embodiment

1-1. Configuration of Audio Processing Apparatus
1-2. Suppression of Howling
1-3. Configuration of Signal Processing Unit
1-4. Howling Suppression Processing

2. Second Embodiment

3. Conclusion

<1. First Embodiment>

(1-1. Configuration of Audio Processing Apparatus)

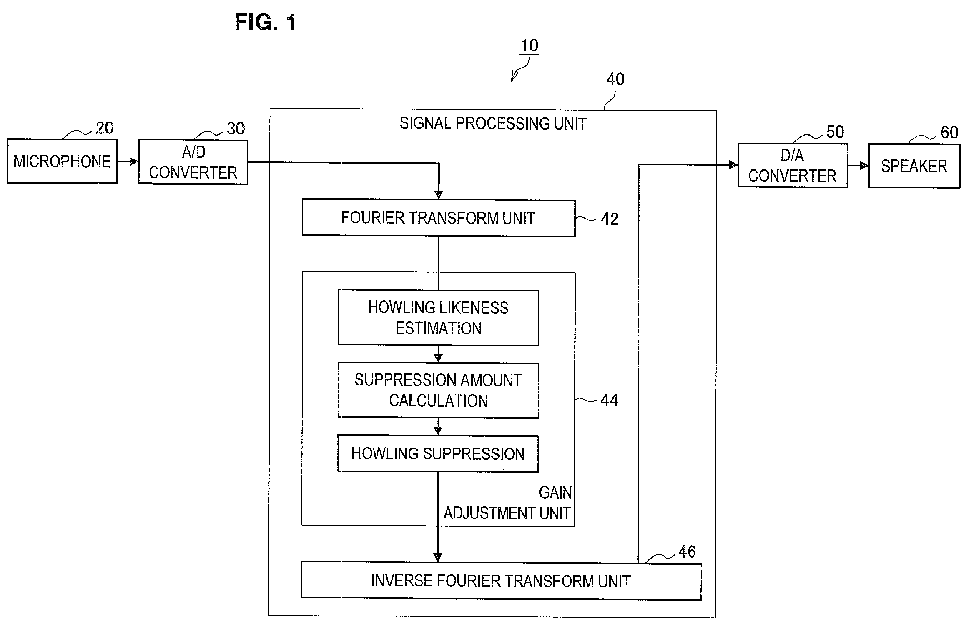

A configuration of an audio processing apparatus according to a first embodiment will be described with reference to FIG. 1. FIG. 1 is a functional block diagram of the audio processing apparatus according to the first embodiment.

As illustrated in FIG. 1, the audio processing apparatus 10 according to the first embodiment includes a microphone 20, an A/D converter 30, a signal processing unit 40, a D/A converter 50, and a speaker 60.

The microphone 20 collects a sound, and converts the collected sound to an audio signal. The mic 20 outputs the audio signal to the A/D converter 30. Additionally, the audio signal output from the microphone 20 is amplified by an amplifier that is not shown in the drawings, and is input to the A/D converter 30.

The A/D converter 30 performs digital conversion on the audio signal input from the microphone 20. The A/D converter 30 outputs the audio signal subjected to the digital conversion to the signal processing unit 40. Additionally, the audio signal input to the A/D converter 30 may be a signal input from an external device other than the microphone 20.

The signal processing unit 40 performs various signal processing such as gain adjustment on the audio signal input from the A/D converter 30. The signal processing unit 40 outputs the audio signal subjected to the signal processing to the D/A converter 50. The signal processing unit 40 according to the present embodiment performs gain adjustment for suppressing howling, which will be described below in detail. A detailed configuration of the signal processing unit 40 will be described below.

The D/A converter 50 performs analog conversion on the audio signal input from the signal processing unit 40. The D/A converter 50 outputs the audio signal subjected to the analog conversion to the speaker 60. The speaker 60 emits the audio signal input from the D/A converter 50.

Additionally, the audio processing apparatus 10 includes memory (not shown) for storing various data. The memory stores, for example, data of an audio signal input from a microphone, and data processed by the signal processing unit 40. The memory also stores a program for operating the audio processing apparatus 10. A CPU that is not shown in the drawings executes the program so that a process (such as howling suppression processing described below) to be performed by the audio processing apparatus 10 is realized.

(1-2. Suppression of Howling)

In the above-described audio processing apparatus, howling may occur while an audio signal is transmitted from the microphone 20 to the speaker 60. It is an important issue to suppress this howling.

Incidentally, upon suppressing howling, it has been known that an indicator for determining howling likeness and a time spent for restoring a howling suppression gain have a great influence on performance of suppressing howling.

First, the indicator for determining howling likeness (in other words, an indicator for detecting howling) will be described. As the indicator for determining howling likeness, a technology has been known which determines howling if, due to counter processing performed on a power difference (Δpower) of audio signals subjected to the Fourier transform, a state continues in which a Δpower value is continuously equal to or more than a threshold value. However, in the actual environment, there is a problem that howling is not properly suppressed due to various reflected sounds, which arrive with delay, and a non-howling sound such as a noise and a sound input to a microphone.

Next, the time spent for restoring the howling suppression gain will be described. If a time spent until a howling suppression gain has been restored is lengthened, there is an advantage that howling does not occur again for some time while there is also probability that quality of a non-howling sound would be degraded during this period. To the contrary, if the time spent until the howling suppression gain has been restored is shortened, quality of a non-howling sound is not so eminently degraded while howling probably occurs again soon or howling is not probably cancelled completely. It is therefore necessary to prevent both sound quality from being degraded and howling from occurring again.

For this object, in the audio processing apparatus 10 according to the present embodiment, an autocorrelation of a power difference of audio signals subjected to the Fourier transform, which will be described below in detail, is used as the indicator for determining howling likeness, and howling suppression is controlled in accordance with the autocorrelation value. It is hereby possible to properly  suppress howling even if a reflected sound and a non-howling sound occur. It is also possible to prevent both the sound quality from being degraded and the howling from occurring again by combining a plurality of amounts of suppression having different suppression times as amounts of howling suppression.

(1-3. Configuration of Signal Processing Unit)

A configuration of the signal processing unit 40 will be described with reference to FIG. 1. As illustrated in FIG. 1, the signal processing unit 40 includes a Fourier transform unit 42, which is an example of a frequency domain transformation unit, a gain adjustment unit 44, and an inverse Fourier transform unit 46, which is a time domain conversion unit.

(Fourier Transform Unit)

The Fourier transform unit 42 performs Fourier transformation (FFT) on an audio signal (input sound) input from the A/D converter 30 for each of frames, which is a unit time, and converts the audio signals to signals in a frequency domain. The Fourier transform unit 42 divides the audio signals, which have been subjected to Fourier transform and converted to the frequency domain, into a plurality of bands, and outputs an audio signal in each band to the gain adjustment unit 44. A known filter bank may divide the audio signals into the plurality of bands.

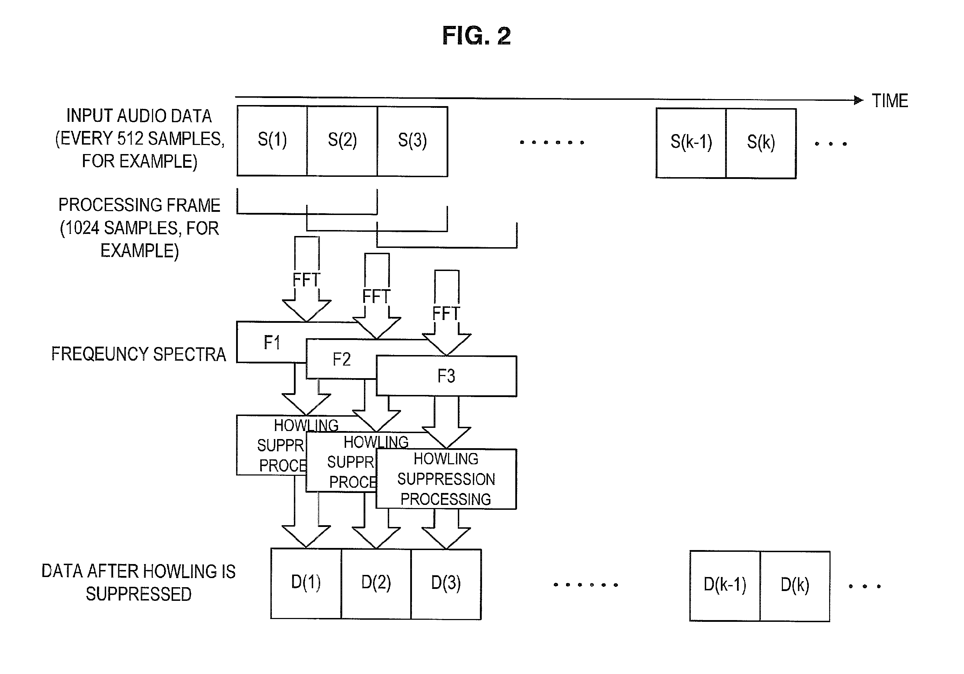

Here, using FIG. 2, block processing in the Fourier transform processing will be described. FIG. 2 is a schematic view for describing the block processing. Here, data of an input sound input from the microphone 20 is, for example, 512 samples, and let us assume that the 512 samples include, for example, samples S(1), S(2), S(3), ... S(n). The Fourier transform is performed using two samples in the block processing. For example, the Fourier transform is performed on both the sample S(1) and the sample S(2) to acquire a frequency spectrum F(1), and the Fourier transform is performed on both the sample S(2) and the sample S(3) to acquire a frequency spectrum F(2). Consequently, a processing frame of the block processing includes 1024 samples.

(Gain Adjustment Unit)

The gain adjustment unit 44 performs gain adjustment on the audio signal input from the Fourier transform unit 42 for each band. The gain adjustment unit 44 also yields a power difference between frames by using a frequency spectrum, and acquires an autocorrelation value for detecting howling. It will be described below how the autocorrelation value is acquired.

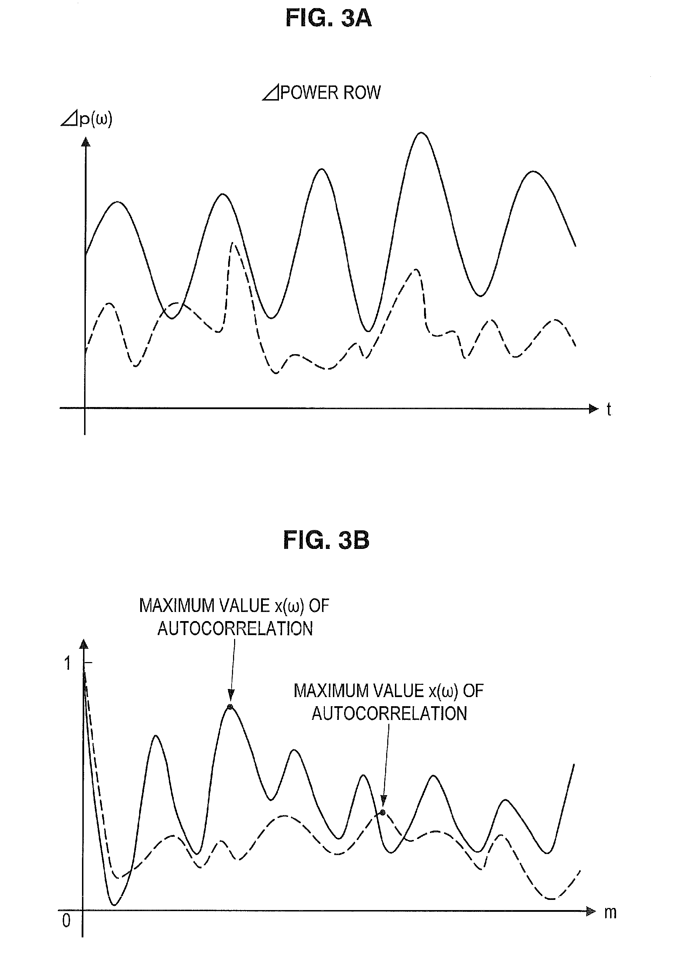

First, the gain adjustment unit 44 acquires a power difference between frames from the acquired frequency spectra F(1), F(2), ... F(n). For example, the gain adjustment unit 44 acquires a power difference $\Delta p(\omega)$ as illustrated in FIG. 3A. FIG. 3A is a diagram illustrating a power difference $\Delta p(\omega)$ in one band. For convenience of explanation, a solid line indicates $\Delta p(\omega)$ during howling, and a dotted line indicates $\Delta p(\omega)$ during non-howling in FIG. 3A. As seen from FIG. 3A, $\Delta P(\omega)$ during howling represents a greater value than $\Delta p(\omega)$ during non-howling.

The gain adjustment unit 44 acquires an autocorrelation of $\Delta p(\omega)$ based on the acquired $\Delta p(\omega)$. Here, the autocorrelation will be described. The autocorrelation is a measurement for measuring to what extent a signal matches a signal obtained by performing time shift on the signal itself. As described in Formula 1 below, the autocorrelation is represented in the form of a function for amplitude of time shift. That is, an autocorrelation $r_m(\omega)$ in Formula 1 is the sum of the product of $\Delta p(\omega)$ and point obtained by shifting $\Delta p(\omega)$ by m points.

[Formula 1]

$$r_m(\omega) = \sum_{t}^{N} \Delta p(\omega, t) \times \Delta p(\omega, t + m) \qquad m = 1, \cdots, N$$

(Formula 1)

Additionally, $\Delta p(\omega, t)$ represents $\Delta$power value of a frequency $\omega$ and time t.

The autocorrelation is useful in finding a repeated pattern included in signals. For example, the autocorrelation is used in determining the presence of periodic signals within noises. If there is periodicity, the autocorrelation has a greater value while the autocorrelation has a smaller value if there is no periodicity. Since $\Delta$power is periodic during howling, a high autocorrelation is shown. Since $\Delta$power is not periodic during non-howling, a low autocorrelation is shown.

The gain adjustment unit 44 uses the acquired autocorrelation $r_m(\omega)$ to acquire an absolute value (referred to as autocorrelation value) of an autocorrelation normalized based on power, as described in Formula 2 below. Normalization based on power makes the autocorrelation between howling and non-howling more distinguishable.

[Formula 2]

$$\left| \frac{r_m(\omega)}{r_0(\omega)} \right| \qquad \text{(Formula 2)}$$

Autocorrelation values acquired from $\Delta p(\omega)$ in FIG. 3A are illustrated in FIG. 3B. FIG. 3B is a diagram illustrating absolute values of the autocorrelation normalized based on power. A solid line indicates autocorrelation values during howling, and a dotted line indicates autocorrelation values during non-howling in FIG. 3B. As seen from FIG. 3B, the autocorrelation values during howling are periodic, and greater than the autocorrelation values during non-howling. Using this nature of the autocorrelation, it is possible to appropriately distinguish howling from non-howling.

In this way, detection of howling using the autocorrelation has an advantage described below over detection of howling using counter processing when $\Delta$power is beyond a threshold value, for example. That is, howling is repeatedly amplified and attenuated to be gradually greater (howling is not simply amplified, but is also sometimes attenuated to be greater) in a short time especially under an environment under which complicated reflection is observed, a $\Delta$power value temporarily becomes small and a counter is reset so that howling is not problematically suppressed. To the contrary, since the present embodiment focuses on only periodicity of $\Delta$power, it is possible to suppress howling even if $\Delta$power temporarily becomes small.

The gain adjustment unit 44 also sets a gain adjustment amount for each band in accordance with the acquired autocorrelation value. Specifically, the gain adjustment unit 44 adjusts a gain for each band by using a combined suppression amount obtained by combining a plurality of suppression amounts. In the present embodiment, the combined suppression amount is described as an amount obtained by combining a long time suppression amount with a short time suppression amount. The long time suppression amount corresponds to a first suppression amount having a long suppression time, and the short time suppression amount corresponds to a second suppression amount having a short suppression time. Additionally, the combined suppression amount may be obtained by combining three or more suppression amounts. For example, when three suppression amounts are used, a suppression time of a third suppression amount is set to be longer than the suppression time of the short time suppression amount and shorter than the suppression time of the long time suppression amount.

The gain adjustment unit 44 compares a maximum value ($x(\omega)$ in FIG. 3B) of the acquired autocorrelation values with a predetermined threshold value to set a combined suppression value (final suppression amount). The predetermined threshold value is a value indicating a border between howling and non-howling. When the maximum value $x(\omega)$ of the autocorrelation values is greater than the threshold value, the gain adjustment unit 44 determines that howling occurs. To the contrary, when the maximum value $x(\omega)$ of the autocorrelation values is smaller than the threshold value, the gain adjustment unit 44 determines that howling does not occur. In addition, when the maximum value of the acquired autocorrelation values is greater than the threshold value, the gain adjustment unit 44 sets a combined suppression amount obtained by increasing the long time suppression amount. To the contrary, when the maximum value of the acquired autocorrelation values is smaller than the threshold value, the gain adjustment unit 44 sets a combined suppression amount obtained by increasing the short time suppression amount.

The gain adjustment unit 44 also performs processing for restoring the long time suppression amount and the short time suppression amount because a frequency characteristic continues to be degraded when howling suppression is continued. The long time suppression amount is slowly restored, and the short time suppression amount is restored fast. By using a plurality of suppression amounts having different times spent for restoring suppression in this way, it is possible to prevent both sound quality from being degraded and howling from occurring again. Data (such as data D(1) and D(2) illustrated in FIG. 2) of an audio signal in each band, which has been subjected to gain adjustment, is output to the inverse Fourier transform unit 46.

(Inverse Fourier Transform Unit)

The inverse Fourier transform unit 46 synthesized the audio signals in each band, which have been input from the Fourier transform unit 46, and performs inverse Fourier transform processing to convert the audio signals to a time domain. The inverse Fourier transform unit 46 according to the present embodiment converts an audio signal whose suppression amount is opened to the time domain. The inverse Fourier transform unit 46 outputs the audio signal converted to the time domain to the D/A converter 50. The audio signal whose suppression amount has been opened is hereby output to the speaker 60.

According to the signal processing unit 40 configured as described above, the gain adjustment unit 44 acquires an autocorrelation value, and sets a final suppression amount in accordance with the acquired autocorrelation value. It is therefore possible to properly suppress howling even if a reflected sound or a non-howling sound occurs. It is also possible to prevent both sound quality from being degraded and howling from occurring again by combining two suppression amounts (long time suppression amount and short time suppression amount) having different suppression times as a final suppression amount.

(1-4. Howling Suppression Processing)

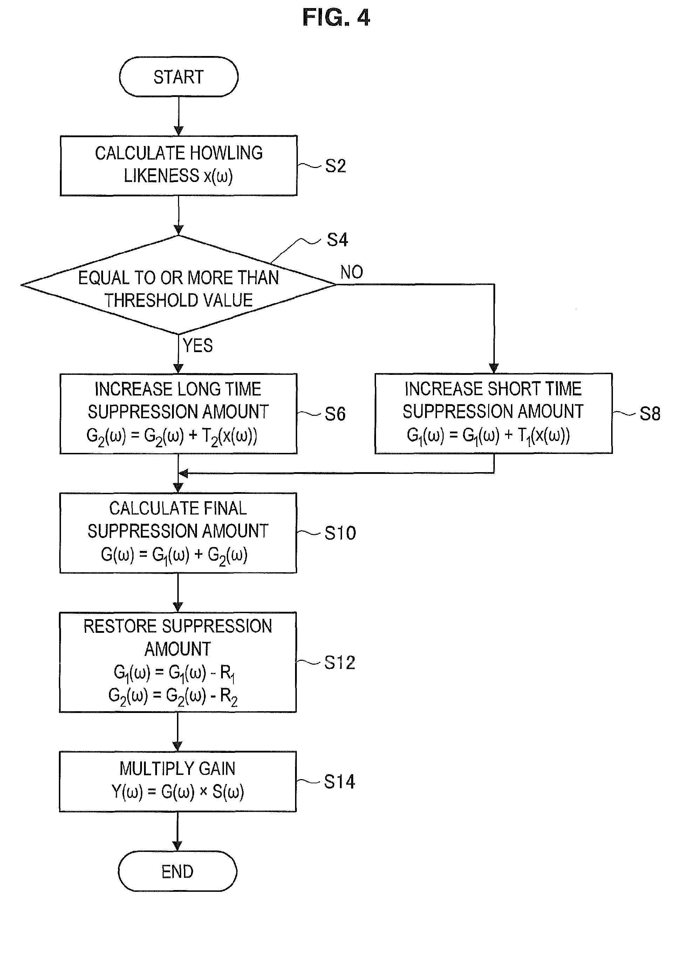

Howling suppression processing according to the present embodiment will be described with reference to FIG. 4. FIG. 4 is a flowchart describing the howling suppression processing. A CPU of the audio processing apparatus 10 executes a program stored in memory to realize the present processing.

The flowchart in FIG. 4 starts when the Fourier transform unit 42 of the signal processing unit 40 converts an audio signal input from the microphone 20 to a frequency domain, and outputs the converted audio signal to the gain adjustment unit 44.

First, the gain adjustment unit 44 acquires a maximum value $x(\omega)$ of autocorrelation values indicating howling likeness, as illustrated in FIG. 3B, based on a power difference $\Delta p(\omega)$ between frames (step S2).

Next, the gain adjustment unit 44 sets a short time suppression amount $G1(\omega)$ and a long time suppression amount $G2(\omega)$ for each band in accordance with the acquired maximum value $x(\omega)$ of the autocorrelation values. The gain adjustment unit 44 sets a final suppression amount $G(\omega)$ obtained by combining the two suppression amounts $G1(\omega)$ and $G2(\omega)$. Additionally, a unit for each suppression amount is a decibel (dB). The present processing is repeated, and then the last values are used as the short time suppression amount $G1(\omega)$ and the long time suppression amount $G2(\omega)$. That is, the short time suppression amount $G1(\omega)$ and the long time suppression amount $G2(\omega)$ are values to be integrated.

Next, the gain adjustment unit 44 determines whether the maximum value $x(\omega)$ of the autocorrelation values is equal to or more than a predetermined threshold value (step S4). When the autocorrelation value $x(\omega)$ is equal to or more than the predetermined threshold value (step S4: Yes), the gain adjustment unit 44 increases the long time suppression amount $G2(\omega)$ of the two suppression amounts $G1(\omega)$ and $G2(\omega)$ (step S6).

For example, the gain adjustment unit 44 increases the long time suppression amount $G2(\omega)$ in accordance with a value of $x(\omega)$, as described in Formula 3 below.

[Formula 3]

$$G2(\omega) = G2(\omega) + T2(x(\omega)) \qquad \text{(Formula 3)}$$

where $T2(x(\omega))$ is, for example, a constant value or a value in proportion to howling likeness, but is not limited thereto.

The gain adjustment unit 44 may also increase the long time suppression amount $G2(\omega)$ by using multiplication, as described in Formula 4 below.

[Formula 4]

$$G2(\omega) = G2(\omega) \times T2(x(\omega)) \qquad \text{(Formula 4)}$$

Additionally, when the maximum value $x(\omega)$ of the autocorrelation values is equal to or more than the predetermined threshold value, the gain adjustment unit 44 retains the amplitude of the short time suppression amount $G1(\omega)$.

To the contrary, if the maximum value $x(\omega)$ of the autocorrelation values is equal to or less than the predetermined value in step S4 (step S4: No), the gain adjustment unit 44 increases the short time suppression amount $G1(\omega)$ of the

two suppression amounts G1(ω) and G2(ω) (step S8).

For example, the gain adjustment unit 44 increases the short time suppression amount G1(ω) in accordance with a value of x(ω), as described in Formula 5 below.

[Formula 5]

$$G1(\omega) = G1(\omega) + T1(x(\omega)) \quad \text{(Formula 5)}$$

where T1(x(ω)) is, for example, a constant value or a value in proportion to howling likeness, but is not limited thereto.

The gain adjustment unit 44 may also increase the short time suppression amount G1(ω) by using multiplication, as described in Formula 6 below.

[Formula 6]

$$G1(\omega) = G1(\omega) \times T1(x(\omega)) \quad \text{(Formula 6)}$$

Additionally, if the maximum value x(ω) of the auto correlation values is equal to or less than the predetermined value, the gain adjustment unit 44 retains the amplitude of the long time suppression amount G2(ω).

Next, the gain adjustment unit 44 yields the final suppression amount G(ω) by combining the two suppression amounts G1(ω) and G2(ω) (step S10). For example, the gain adjustment unit 44 yields the final suppression amount G(ω), as described in Formula 7 below.

[Formula 7]

$$G(\omega) = G1(\omega) + G2(\omega) \quad \text{(Formula 7)}$$

The gain adjustment unit 44 yields the final suppression amount G(ω) by combining the two suppression amounts G1(ω) and G2(ω), but the way of yielding the final suppression amount G(ω) is not limited thereto. For example, the gain adjustment unit 44 may adopt one of the two suppression amounts G1(ω) and G2(ω) that has the greater suppression gain as the final suppression amount G(ω) when focusing on suppressing howling. The gain adjustment unit 44 may also adopt the suppression amount that has the smaller suppression gain as the final suppression amount G(ω) when focusing on quality of a non-howling sound.

Incidentally, the gain adjustment unit 44 performs processing for restoring a suppression amount (step S12) because a frequency characteristic continues to be degraded when howling suppression is continued. For example, the gain adjustment unit 44 controls a suppression gain, as described in Formulas 8 and 9 below. Additionally, a short time suppression amount G1(ω) and a long time suppression amount G2(ω) obtained by restoring the suppression amounts are used in step S6 and S8.

[Formula 8]

$$G1(\omega) = G1(\omega) - R1 \quad \text{(Formula 8)}$$

[Formula 9]

$$G2(\omega) = G2(\omega) - R2 \quad \text{(Formula 9)}$$

Let us assume here that R1 is a value greater than R2. Consequently, the short suppression amount G1(ω) is restored in a short time, while the long time suppression amount G2(ω) is restored slowly. That is, when howling likeness is small (autocorrelation value is small), the gain is restored fast. When howling likeness is great (autocorrelation value is great), the gain is restored slowly.

The more detailed description will be made regarding this point. It is needed to start suppression when an autocorrelation value x(ω) is still small in order to perform suppression before howling stands out. However, if suppression has been performed since the correlation value x(ω) is still small, a non-howling sound such as a voice is possibly suppressed by mistake. Meanwhile, since the short time suppression amount G1(ω) is restored fast in the present embodiment, a non-howling sound is prevented from being degraded by mistake suppression.

When howling is actually occurring, the howling is suppressed by using the long time suppression amount G2(ω) because the autocorrelation value x(ω) becomes a great value during the short time suppression. At this time, the howling is not so much outstanding in the present embodiment because the howling is suppressed by using the short time suppression amount G1(ω). Since the howling also continues to be suppressed for a long time by using the long time suppression amount G2(ω), the howling can be prevented from occurring again soon.

Incidentally, when howling is suppressed by using only the short time suppression amount G1(ω), quality degradation of a non-howling sound does not stand out while the howling occurs problematically again soon or is not cancelled completely. To the contrary, when howling is suppressed by using only the long time suppression amount G2(ω), the howling does not occur again for some time while a non-howling sound is problematically degraded. For these problems, suppression is performed by using a plurality of suppression amounts G1(ω) and G2(ω) having different suppression times in the present embodiment described above so that suppression is properly performed even when a non-howling sound occurs. It is also possible to prevent both sound quality from being degraded and howling from occurring again.

Returning to the flowchart in FIG. 4, the description of the processing will be made. The gain adjustment unit 44 multiplies an input S(ω) by the yielded final suppression amount G(ω), as described in Formula 10 below, to acquire the processed output Y(ω) (step S 14).

[Formula 10]

$$Y(\omega) = G(\omega) \times S(\omega) \quad \text{(Formula 10)}$$

An audio signal subjected to the howling suppression processing is output to the speaker 60.

The processing in step S14 is performed after the processing in step S12 above, but the order is not limited thereto. For example, the processing in step S12 and the processing in step S 14 may be performed in parallel. The processing in step S 12 may be performed after the processing in step S 14.

<2. Second Embodiment>

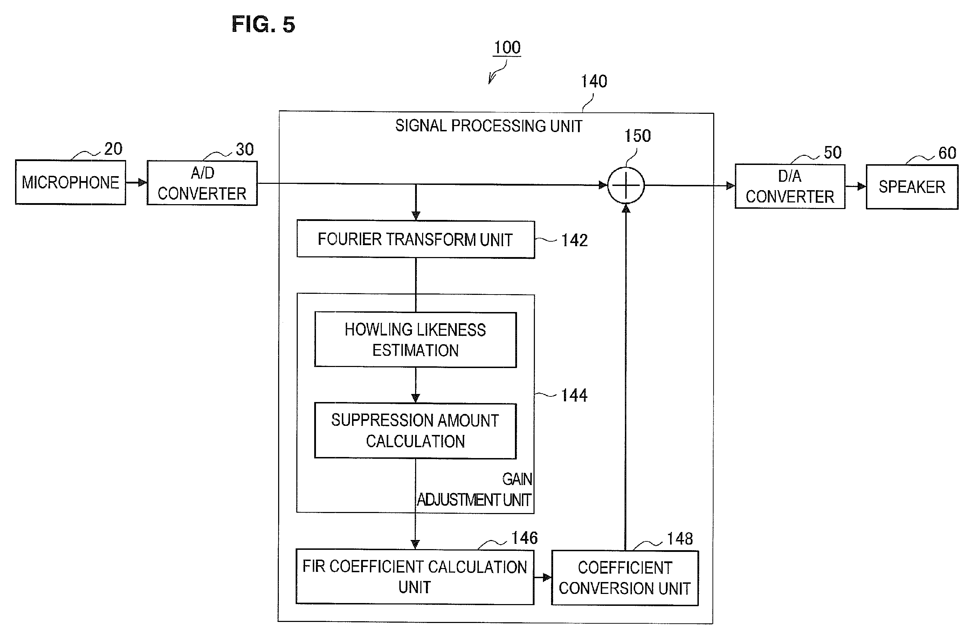

An audio processing apparatus according to a second embodiment will be described with reference to FIG. 5. FIG. 5 is a functional block diagram of the audio processing apparatus according to the second embodiment.

The suppression gain G(ω) of howling is multiplied in the frequency domain in the above-described first embodiment. Meanwhile, howling is suppressed in the time domain by using an FIR coefficient having a minimum phase, which will be described in detail below, in the second embodiment. Delay of an output sound, which may occur due to the block processing of the Fourier transform (see FIG. 2), can be hereby overcome.

Compared with the audio processing apparatus 10 according to the first embodiment, an audio processing apparatus 100 according to the second embodiment in FIG. 5 has the signal processing unit 40 configured differently, and the others configured in the same way. Mainly, the configuration of the signal processing unit 140 in the audio processing apparatus 100 will therefore be described below, and the description for the other configurations will be omitted.

The signal processing unit 140 performs various signal processing such as gain adjustment on an audio signal (input sound) input from the A/D converter 30, and outputs the audio signal subjected to the signal processing to the D/A converter 50. The signal processing unit 140 includes a Fourier transform unit 142, a gain adjustment unit 144, an FIR coefficient calculation unit 146, a coefficient conversion unit 148, and a convolution unit 150.

The Fourier transform unit 142 divides audio signals converted to the frequency domain into a plurality of bands in the same way as the first embodiment, and outputs the audio signal in each band to the gain adjustment unit 144.

The gain adjustment unit 144 acquires an autocorrelation value in the same way as the first embodiment, and sets a final suppression amount G(ω) in accordance with the acquired autocorrelation value. Consequently, howling can also be properly suppressed in the second embodiment even if a reflected sound or a non-howling sound occurs. The gain adjustment unit 144 can also prevent both sound quality from being degraded and howling from occurring again by combining a plurality of suppression amounts and performing suppression.

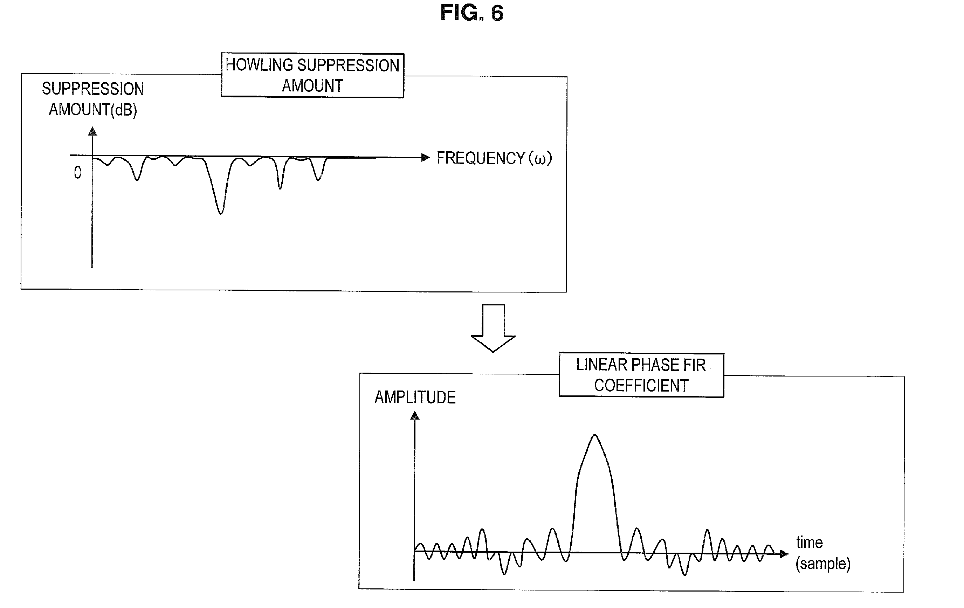

The FIR coefficient calculation unit 146 calculates a linear phase FIR filter coefficient for realizing the final suppression amount G($\omega$) input from the gain adjustment unit 144. For example, the FIR coefficient calculation unit 146 calculates the linear phase FIR filter coefficient by using the window function method, the Remez method, and the like, which have been known, as illustrated in FIG. 6. The FIR coefficient calculation unit 146 outputs the calculated linear phase FIR filter coefficient to the coefficient conversion unit 148. Naturally, the linear phase FIR filter coefficient may be calculated by using a technology other than the window function method and the Remez method. FIG. 6 is a diagram for describing the linear phase FIR filter coefficient.

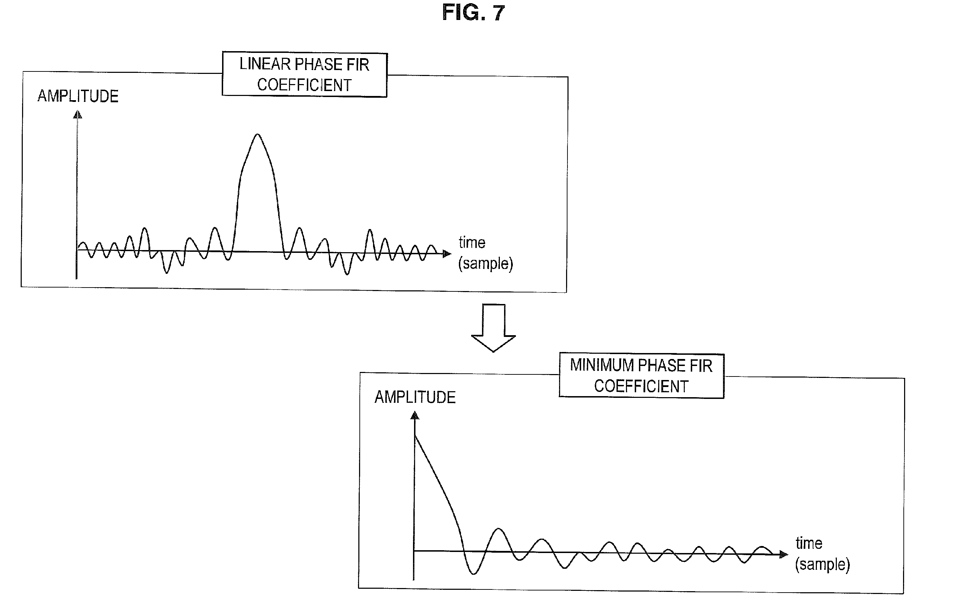

The coefficient conversion unit 148 converts the linear phase FIR filter coefficient input from the FIR coefficient calculation unit 146 to a minimum phase FIR filter coefficient. For example, as illustrated in FIG. 7, the coefficient conversion unit 148 converts the FIR filter coefficient to the minimum phase FIR filter coefficient by using the know method such as the Remez method. The coefficient conversion unit 148 outputs the minimum phase FIR filter coefficient to the convolution unit 150. Additionally, FIG. 7 is a diagram for describing the conversion of the FIR filter coefficient to the minimum phase FIR filter coefficient.

The convolution unit 150 convolutes the minimum phase FIR filter coefficient output from the coefficient conversion unit 148 with an input sound (input sound in the time domain) from the microphone 20. The convolution unit 150 outputs the input sound with which the minimum phase FIR filter coefficient has been convoluted to the speaker 60 via the D/A converter 50.

In this way, according to the second embodiment, the minimum phase FIR filter coefficient is convoluted with the input sound so that it is possible to suppress howling in the time domain by using the minimum phase FIR coefficient. As a result, it is possible to suppress howling without delay in the input sound.

<3. Conclusion>

In the above-described audio processing apparatuses 10 and 100, the gain adjustment unit 44 acquires the autocorrelation value x($\omega$) of power of the audio signals between the frames for each band, and sets an adjustment amount of a gain in accordance with the acquired autocorrelation value x($\omega$). According to the configuration, if an autocorrelation of power differences of howling having periodicity is used, it is possible to appropriately detect the howling even when a reflected sound or a non-howling sound occurs. As a result, it is possible to properly suppress howling.

Meanwhile, the gain adjustment unit 44 adjusts, for each band, a gain by using the combined suppression amount G($\omega$) obtained by combining the long time suppression amount G2($\omega$) having a long suppression time with the short time suppression amount G1($\omega$) having a short suppression time. According to the configuration, the long time suppression amount G2($\omega$) and the short time suppression amount G1($\omega$) each have a different time used in restoring the suppression amount to resolve a problem arising in performing suppression with only one suppression amount. That is, it is possible to prevent both sound quality from being degraded and howling from occurring again, which are problematic in suppressing howling.

The preferred embodiments of the present invention have been described above with reference to the accompanying drawings, whilst the present invention is not limited to the above examples, of course. A person skilled in the art may find various alternations and modifications within the scope of the appended claims, and it should be understood that they will naturally come under the technical scope of the present invention.

The audio processing apparatus includes both the microphone and the speaker in the above-described embodiments, but it is not necessarily the case. For example, the audio processing apparatus does not have to include the microphone and the speaker, and the microphone and the speaker may be provided in an external apparatus connected to the audio processing apparatus.

The series of processing, which have been described in the above-described embodiments, may be executed by dedicated hardware or software (application). When the series of processing are executed by software, the series of processing can be executed by causing a general-purpose or dedicated computer to execute a program.

The steps illustrated in the flowchart in the above-described embodiment naturally include processing that is chronologically performed in order of mention, and also include processing that is not necessarily chronologically performed, but is performed in parallel or is individually performed. Needless to say, it is possible to change the order as necessary even in the chronologically performed steps.

Reference Signs List

10    Audio processing apparatus
20    Microphone

30    A/D converter
40    Signal processing unit
42    Fourier transform unit
44    Gain adjustment unit
46    Inverse Fourier transform unit
50    D/A converter
60    Speaker
100   Audio processing apparatus
140   Signal processing unit
142   Fourier transform unit
144   Gain adjustment unit
146   FIR coefficient calculation unit
148   Coefficient conversion unit
150   Convolution unit

**Claims**

1. An audio processing apparatus comprising:

   a frequency domain conversion unit configured to convert an audio signal input from a microphone to a frequency domain for each of frames; and
   a gain adjustment unit configured to perform gain adjustment for each of bands on the audio signal converted to the frequency domain,
   wherein the gain adjustment unit acquires an autocorrelation value of power of the audio signal between the frames for each of the bands, and sets an adjustment amount of the gain in accordance with the acquired autocorrelation value.

2. The audio processing apparatus according to claim 1, wherein the adjustment amount includes a first suppression amount having a long time for suppressing the gain, and a second suppression amount having a short time for suppressing the gain.

3. The audio processing apparatus according to claim 2, wherein the gain adjustment unit sets a combined suppression amount for each of the bands, the combined suppression amount being a combination of the first suppression amount and the second suppression amount.

4. The audio processing apparatus according to claim 3, wherein the gain adjustment unit sets the combined suppression amount obtained by increasing the first suppression amount when a maximum value of the acquired autocorrelation value is greater than a predetermined threshold value, and sets the combined suppression amount obtained by increasing the second suppression amount when the maximum value of the acquired autocorrelation value is smaller than the threshold value.

5. The audio processing apparatus according to claim 1, wherein the autocorrelation value of the power is an absolute value of an autocorrelation normalized based on the power.

6. The audio processing apparatus according to claim 1, further comprising:

   a time domain conversion unit configured to convert the audio signal subjected to gain adjustment by the gain adjustment unit to a time domain; and
   an output unit configured to output the audio signal converted to the time domain to a speaker.

7. The audio processing apparatus according to claim 1, further comprising:

   a coefficient conversion unit configured to convert a filter coefficient to a minimum phase filter coefficient, the filter coefficient corresponding to the adjustment amount of the gain according to the autocorrelation value; and
   a convolution unit configured to convolute the minimum phase filter coefficient with the audio signal in the time domain, the audio signal being input from the microphone.

8. An audio processing apparatus comprising:

a frequency domain conversion unit configured to convert an audio signal input from a microphone to a frequency domain for each of frames; and
a gain adjustment unit configured to perform gain adjustment for each of bands on the audio signal converted to the frequency domain,
wherein the gain adjustment unit adjusts the gain for each of the bands with a combined suppression amount obtained by combining a first suppression amount having a long suppression time with a second suppression amount having a short  suppression time.

9. An audio processing method comprising:

converting an audio signal input from a microphone to a frequency domain for each of frames; and
performing gain adjustment for each of bands on the audio signal converted to the frequency domain,
wherein, in performing the gain adjustment, an autocorrelation value of power of the audio signal between the frames for each of the bands is acquired, and an adjustment amount of the gain is set in accordance with the acquired autocorrelation value.

10. An audio processing method comprising:

converting an audio signal input from a microphone to a frequency domain for each of frames; and
performing gain adjustment for each of bands on the audio signal converted to the frequency domain,
wherein, in performing the gain adjustment, the gain is adjusted for each of the bands with a combined suppression amount obtained by combining a first suppression amount having a long suppression time with a second suppression amount having a short suppression time.

11. A program for causing a computer to function as an audio processing apparatus, the audio processing apparatus including
a frequency domain conversion unit configured to convert an audio signal input from a microphone to a frequency domain for each of frames, and
a gain adjustment unit configured to perform gain adjustment for each of bands on the audio signal converted to the frequency domain,
wherein the gain adjustment unit acquires an autocorrelation value of power of the audio signal between the frames for each of the bands, and sets an adjustment amount of the gain in accordance with the acquired autocorrelation value.

12. A program for causing a computer to function as an audio processing apparatus, the audio processing apparatus including
a frequency domain conversion unit configured to convert an audio signal input from a microphone to a frequency domain for each of frames, and
a gain adjustment unit configured to perform gain adjustment for each of bands on the audio signal converted to the frequency domain,
wherein the gain adjustment unit adjusts the gain for each of the bands with a combined suppression amount obtained by combining a first suppression amount having a long suppression time with a second suppression amount having a short suppression time.

**FIG. 1**

MICROPHONE ~20 → A/D CONVERTER ~30 → SIGNAL PROCESSING UNIT ~40 → D/A CONVERTER ~50 → SPEAKER ~60

Within SIGNAL PROCESSING UNIT (40), with reference 10:

FOURIER TRANSFORM UNIT ~42

GAIN ADJUSTMENT UNIT ~44:
- HOWLING LIKENESS ESTIMATION
- SUPPRESSION AMOUNT CALCULATION
- HOWLING SUPPRESSION

INVERSE FOURIER TRANSFORM UNIT ~46

EP 2 680 609 A1

# FIG. 2

INPUT AUDIO DATA (EVERY 512 SAMPLES, FOR EXAMPLE): S(1) | S(2) | S(3) ...... S(k-1) | S(k) ...

TIME →

PROCESSING FRAME (1024 SAMPLES, FOR EXAMPLE)

FFT, FFT, FFT

FREQEUNCY SPECTRA: F1, F2, F3

HOWLING SUPPRESSION PROCESSING

DATA AFTER HOWLING IS SUPPRESSED: D(1) | D(2) | D(3) ...... D(k-1) | D(k) ...

EP 2 680 609 A1

# FIG. 3A

△POWER ROW

# FIG. 3B

MAXIMUM VALUE $x(\omega)$ OF AUTOCORRELATION

MAXIMUM VALUE $x(\omega)$ OF AUTOCORRELATION

# FIG. 4

START

CALCULATE HOWLING
LIKENESS $x(\omega)$ — S2

EQUAL TO OR MORE THAN
THRESHOLD VALUE — S4

NO

YES

INCREASE LONG TIME
SUPPRESSION AMOUNT
$G_2(\omega) = G_2(\omega) + T_2(x(\omega))$ — S6

INCREASE SHORT TIME
SUPPRESSION AMOUNT
$G_1(\omega) = G_1(\omega) + T_1(x(\omega))$ — S8

CALCULATE FINAL
SUPPRESSION AMOUNT
$G(\omega) = G_1(\omega) + G_2(\omega)$ — S10

RESTORE SUPPRESSION
AMOUNT
$G_1(\omega) = G_1(\omega) - R_1$
$G_2(\omega) = G_2(\omega) - R_2$ — S12

MULTIPLY GAIN
$Y(\omega) = G(\omega) \times S(\omega)$ — S14

END

**FIG. 5**

EP 2 680 609 A1

# FIG. 6

HOWLING SUPPRESSION
AMOUNT

SUPPRESSION
AMOUNT(dB)

FREQUENCY(ω)

0

LINEAR PHASE FIR
COEFFICIENT

AMPLITUDE

time
(sample)

## FIG. 7

LINEAR PHASE FIR
COEFFICIENT

AMPLITUDE

time
(sample)

MINIMUM PHASE FIR
COEFFICIENT

AMPLITUDE

time
(sample)

EP 2 680 609 A1

<div style="text-align:center">**INTERNATIONAL SEARCH REPORT**</div>

| International application No. |
|---|
| PCT/JP2012/053418 |

**A. CLASSIFICATION OF SUBJECT MATTER**
*H04R3/02*(2006.01)i

According to International Patent Classification (IPC) or to both national classification and IPC

**B. FIELDS SEARCHED**

Minimum documentation searched (classification system followed by classification symbols)
H04R3/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2003-32780 A (Matsushita Electric Industrial Co., Ltd.), 31 January 2003 (31.01.2003), paragraphs [0098] to [0140]; fig. 1 to 4 & US 2003/0012388 A1 & EP 1278396 A2 & CN 1398054 A | 1,6,9,11<br>2-5,7,8,10,<br>12 |
| Y<br>A | JP 2003-274480 A (Matsushita Electric Industrial Co., Ltd.), 26 September 2003 (26.09.2003), paragraphs [0033] to [0083]; fig. 1 to 8 & US 2004/0170283 A1 & EP 1404148 A1 & WO 2003/077594 A1 & DE 60315228 D & DE 60315228 T & CA 2447144 A & CN 1511430 A & DK 1404148 T & AU 2003213325 A | 1,6,9,11<br>2-5,7,8,10,<br>12 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>19 March, 2012 (19.03.12) | Date of mailing of the international search report<br>03 April, 2012 (03.04.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/053418

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2006-121188 A (Matsushita Electric Industrial Co., Ltd.), 11 May 2006 (11.05.2006), paragraphs [0039] to [0066]; fig. 1 to 5 & WO 2006/043367 A1 | 1,6,9,11<br>2-5,7,8,10, 12 |
| Y<br>A | JP 63-1296 A (Matsushita Electric Industrial Co., Ltd.), 06 January 1988 (06.01.1988), page 2, lower right column, line 4 to page 3, upper right column, line 13; fig. 1 (Family: none) | 1,6,9,11<br>2-5,7,8,10, 12 |
| A | JP 2005-236713 A (Matsushita Electric Industrial Co., Ltd.), 02 September 2005 (02.09.2005), entire text; all drawings & US 2007/0280487 A1 & EP 1725069 A1 & WO 2005/081577 A & CN 1934897 A | 1-12 |

Form PCT/ISA/210 (continuation of second sheet) (July 2009)

| **INTERNATIONAL SEARCH REPORT** | International application No. |
|---|---|
| | PCT/JP2012/053418 |

| **Box No. II** | **Observations where certain claims were found unsearchable (Continuation of item 2 of first sheet)** |
|---|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| **Box No. III** | **Observations where unity of invention is lacking (Continuation of item 3 of first sheet)** |
|---|---|

This International Searching Authority found multiple inventions in this international application, as follows:
   See extra sheet

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2012/053418

Continuation of Box No.III of continuation of first sheet(2)

The invention in claim 1 and the invention in claim 8 have common technical features of a frequency range converting unit for converting, for each frame, a voice signal input from a microphone to a frequency range, and a gain adjusting unit for performing, for each band, gain adjustment to the voice signal having been converted into the frequency range. However, the above-said technical feature cannot be considered to be a special technical feature, since the technical feature does not make a contribution over the prior art in the light of the contents disclosed in the document 1 (JP 2003-32780 A (Matsushita Electric Industrial Co., Ltd.), 31 January 2003 (31.01.2003), paragraphs [0098] to [0140]; fig. 1 to 4), the document 2 (JP 2003-274480 A (Matsushita Electric Industrial Co., Ltd.), 26 September 2003 (26.09.2003), paragraphs [0033] to [0083]; fig. 1 to 8), and the document 3 (JP 2006-121188 A (Matsushita Electric Industrial Co., Ltd.), 11 May 2006 (11.05.2006), paragraphs [0039] to [0066]; fig. 1 to 5). Further, there is no other same or corresponding special technical feature between these inventions. Accordingly, the following two inventions (invention groups) are involved in claims.
Meanwhile, since claims 9, 11 have a category different from that in claim 1 and claims 10, 12 have a category different from that in claim 8, claims 9, 11 and claims 10, 12 are classified into invention 1 and invention 2, respectively.

Invention 1: The invention in claims 1-7, 9 and 11
A voice information processing device which includes a frequency range converting unit for converting, for each frame, a voice signal input from a microphone to a frequency range, and a gain adjusting unit for performing, for each band, gain adjustment to the voice signal having been converted into the frequency range, wherein the gain adjusting unit obtains, for each band, an autocorrelation value in the power of the voice signal between the frames, and sets an adjustment amount of the gain in accordance with the autocorrelation value thus obtained.

Invention 2: The invention in claims 8, 10 and 12
A voice information processing device which includes a frequency range converting unit for converting, for each frame, a voice signal input from a microphone to a frequency range, and a gain adjusting unit for performing, for each band, gain adjustment to the voice signal having been converted into the frequency range, wherein the gain adjusting unit adjusts, for each band, the gain on the basis of a combined suppression amount obtained by combining a first suppression amount having a long suppression time and a second suppression amount having a short suppression time.

Form PCT/ISA/210 (extra sheet) (July 2009)

**EP 2 680 609 A1**

**REFERENCES CITED IN THE DESCRIPTION**

**Patent documents cited in the description**

- JP H8223684 A

- JP H3237899 A